# EUROPEAN PATENT APPLICATION

(11) **EP 4 841 492 A1**
(43) Date of publication of application: **18.11.2026**
(21) Application number: 26154543.8
(22) Date of filing: 27.01.2026
(51) Int. Cl.: G06F 30/12, G06F 16/33, G06F 30/27, G06F 40/10, G06F 8/71, G06F 30/15, G06F 40/197, G06F 40/30

(54) **DESIGN DOCUMENT EDITING SUPPORT APPARATUS AND DESIGN DOCUMENT EDITING SUPPORT METHOD**

(30) Priority: 15.05.2025 JP 2025081642
(71) Applicant: Hitachi, Ltd., Tokyo 100-8280 (JP)
(72) Inventor: UCHIYAMA, Yuya, Chiyoda-ku, 100-8280 (JP)
(74) Representative: Mewburn Ellis LLP

(57) **Abstract**

To provide a design document editing support apparatus and a design document editing support method capable of reducing man-hours for editing design documents to accommodate product design changes and preventing omissions in the work. The design document editing support apparatus extracts, from the content included in design change information, a change location for the target product and a change target and change content of the change target related to the change location, identifies, based on the extracted change location, a change element corresponding to the change location from among a plurality of elements included in a systems model, searches, as an impact range, the identified change element and elements connected to the identified change element in the systems model, and identifies, in the design document, a description portion corresponding to the searched impact range.

## Description

### Technical Field

The present disclosure relates to a design document editing support apparatus and a design document editing support method.

### Background Art

In recent years, with the diversification and advancement of products, design changes have been increasingly implemented to add new functions to existing products. Such design changes are generally carried out based on existing products and play an important role in enhancing the competitiveness of products.

In product design, not only design drawings but also design documents indicating product specifications, required performance, and operating conditions are widely used. These design documents describe matters related to product design, manufacturing, and operation, and are important elements that contribute to product quality and reliability.

When making design changes to a product, it is necessary to modify the content of the design documents so as to correspond to the design changes. In recent years, there has been a tendency for product structures and functions to become more complex, and accordingly, the workload for editing design documents due to design changes tends to increase.

Furthermore, as products become more complex, the areas affected by design changes may extend beyond the parts being changed, and work may be required to reflect such effects in the design documents and maintain consistency throughout the documents. In addition, when the areas affected by design changes become extensive, the risk of omissions in the editing work of the design documents increases. Such omissions can cause inconsistencies between the design documents and the actual product, thereby affecting product quality and reliability.

Accordingly, in product design changes, understanding the content related to the design changes and the associated impacts, and supporting the editing work of design documents contributes not only to improving design efficiency and reducing work time during design changes, but also to ensuring product quality and reliability.

As a technique for investigating the content of design documents and creating and editing documents in response to product design changes, the following prior art has been proposed. Patent Document 1 discloses a specification creation support apparatus, a specification creation support program, and a specification creation support method for reducing rework from external specifications to basic planning in software that executes equipment control.

### Citation list

### Patent Literature

Patent Document 1: Japanese Patent Application Laid-Open No.2005-128736

### Summary of Invention

### Technical Problem

In order to reduce the man-hours required for editing design documents due to product design changes and to prevent omissions in the work, it is necessary, in addition to techniques that substitute for the actual editing work of design documents, to present locations that should be checked during editing within a range that includes areas affected by the design changes. To achieve this, a technique is required that identifies areas affected by the design changes and searches for words or sentences in the design documents corresponding to those areas, and presents them to the user.

Patent Document 1 describing the prior art takes as input a design document before editing and a design document after editing, and identifies portions in the design document that should be changed based on the differences between them, and presents portions that have not yet been changed in the design document after editing. Therefore, a technique is needed that identifies the range affected by the design changes and also identifies corresponding portions in the design document.

Since the prior art does not utilize information such as product requirements to calculate the impact of design changes, it is difficult to sufficiently prevent omissions in the editing work of design documents.

The present disclosure has been made to solve the above problems. That is, one of the objectives of the present disclosure is to provide a design document editing support apparatus and a design document editing support method that can reduce the man-hours required for editing design documents to accommodate product design changes and prevent omissions in the work.

### Solution to Problem

To solve the above problem, the design document editing support apparatus of the present disclosure includes an information processing device, wherein the information processing device acquires product model information representing a target product by a plurality of elements hierarchically connected, a design document, and design change information; extracts, from the content included in the design change information, a change location for the target product and a change target and change content of the change target related to the change location; identifies, based on the extracted change location, a change element corresponding to the change location from among the plurality of elements included in the product model information; searches, as an impact range, the identified change element and elements connected to the identified change element in the product model information; and identifies, in the design document, a description portion corresponding to the searched impact range.

The design document editing support method of the present disclosure is a design document editing support method using an information processing device, wherein the information processing device acquires product model information representing a target product by a plurality of elements hierarchically connected, a design document, and design change information; extracts, from the content included in the design change information, a change location for the target product and a change target and change content of the change target related to the change location; identifies, based on the extracted change location, a change element corresponding to the change location from among the plurality of elements included in the product model information; searches, as an impact range, the identified change element and elements connected to the identified change element in the product model information; and identifies, in the design document, a description portion corresponding to the searched impact range.

### Advantageous Effect

According to the present disclosure, it is possible to reduce the man-hours required for editing design documents to accommodate product design changes and to prevent omissions in the work. It should be noted that the effects described herein are not necessarily limiting, and any of the effects described in the present disclosure may be adopted. In addition, issues, configurations, and effects other than those described above will become apparent from the description of the embodiments of the present disclosure below.

### Brief Description of Drawings

FIG. 1 is a block diagram of a design document editing support apparatus according to Example 1.
FIG. 2A is an example of a systems model according to the present disclosure.
FIG. 2B is a script written in a modeling language according to the present disclosure.
FIG. 3 is an example of a design document related to a product according to the present disclosure.
FIG. 4 is an example of design change information according to the present disclosure.
FIG. 5 is an example of processing by the design change information processing unit 102 according to Example 1 of the present disclosure.
FIG. 6 is a flowchart of the design change information processing unit 102 according to Example 1 of the present disclosure.
FIG. 7 is an example of processing by the impact range search unit 103 according to Example 1 of the present disclosure.
FIG. 8 is a flowchart of the impact range search unit 103 according to Example 1 of the present disclosure.
FIG. 9 is an example of processing by the relevant document search unit 104 according to Example 1 of the present disclosure.
FIG. 10 is a flowchart of the relevant document search unit 104 according to Example 1 of the present disclosure.
FIG. 11 is an example of processing by the document content modification processing unit 105 according to Example 1 of the present disclosure.
FIG. 12 is a flowchart of the document content modification processing unit 105 according to Example 1 of the present disclosure.
FIG. 13 is a block diagram of a design document editing support apparatus according to Example 2.
FIG. 14 is an example of processing by the systems model acquisition unit 1301 according to Example 2 of the present disclosure.
FIG. 15 is a flowchart of the systems model acquisition unit 1301 according to Example 2 of the present disclosure.
FIG. 16 is an example of processing by the design document acquisition unit 1302 according to Example 2 of the present disclosure.
FIG. 17 is a flowchart of the design document acquisition unit 1202 according to Example 2 of the present disclosure.
FIG. 18 is a diagram illustrating an example of a hardware configuration of a computer applied to the design document editing support apparatus.

### Description of Embodiments

Hereinafter, embodiments of the present disclosure will be described with reference to the drawings. It should be noted that the drawings illustrate specific embodiments based on the principles of the present disclosure, and these are provided for understanding the present disclosure and are not intended to be used to interpret the present disclosure in a limiting manner. In all the drawings of the embodiments, the same reference numerals may be assigned to identical or corresponding parts.

The embodiments (examples) are illustrative for explaining the present disclosure, and omissions and simplifications have been made as appropriate for clarity of explanation. The present disclosure can be implemented in various other forms. Unless otherwise specified, each component may be singular or plural.

The positions, sizes, shapes, and ranges of the components shown in the drawings may not represent actual positions, sizes, shapes, and ranges, but are provided to facilitate understanding of the invention. Therefore, the present disclosure is not necessarily limited to the positions, sizes, shapes, and ranges disclosed in the drawings.

In the embodiments (examples), processing performed by executing a program may be described. Here, a computer executes the program by a processor (e.g., CPU, GPU) and performs processing defined by the program while using resources such as memory and interface devices (e.g., communication ports). Therefore, the entity that performs the processing by executing the program may be the processor. Similarly, the entity that performs the processing by executing the program may be a controller, device, or computer having a processor. The entity that performs the processing by executing the program may be any arithmetic unit and may include a dedicated circuit for performing specific processing. Examples of such dedicated circuits include FPGA (Field Programmable Gate Array), ASIC (Application Specific Integrated Circuit), and CPLD (Complex Programmable Logic Device).

The program may be installed in the computer from a program source. The program source may be, for example, a program distribution server or a storage medium readable by the computer. When the program source is a program distribution server, the program distribution server includes a processor and storage resources for storing the program to be distributed, and the processor of the program distribution server may distribute the program to be distributed to other computers. In addition, in the embodiments, two or more programs may be implemented as one program, or one program may be implemented as two or more programs.

The present disclosure relates to an editing support apparatus and a design document editing support method that support editing work of design documents by presenting locations to be changed in the design documents during design changes, using a systems model indicating requirements for the target product. The systems model indicating requirements for the target product may be referred to as "product model information." The product model information represents the product by a plurality of elements hierarchically connected.

In the present disclosure, in order to identify areas affected by design changes of a product, a technique that covers information such as the structure, functions, and requirements of the product is required, and a systems model based on MBSE (Model-Based Systems Engineering) (also referred to as "system model") is utilized. The systems model is described using a dedicated computer language called a modeling language, and for each item (element) such as the structure, functions, and requirements of the product, the inclusion relationships and parent-child relationships of the items (elements) are described and visualized as a tree structure. By utilizing the systems model, it is possible to identify the range affected by design changes.

An example of the design document editing support apparatus of the present disclosure includes: an input unit that inputs a systems model, a design document, and design change information corresponding to a target product; an impact range search unit that extracts, from the content included in the design change information, a change location for the target product and a change target and change content (e.g., change amount) related to the change location and that, based on the extracted change location, identifies a change element corresponding to the change location from among a plurality of elements (items) included in the systems model, and searches for the identified change element and elements (items) connected to the identified change element in the systems model as an impact range; a relevant document search unit that identifies portions of the design document corresponding to the searched impact range; a document content processing unit that changes the display mode of the identified portions corresponding to the impact range to a mode different from others and, when possible, replaces the content of the document with the content extracted by the design change information processing unit; and an output unit that outputs the design document processed by the document content modification processing unit.

### <<Example 1>>

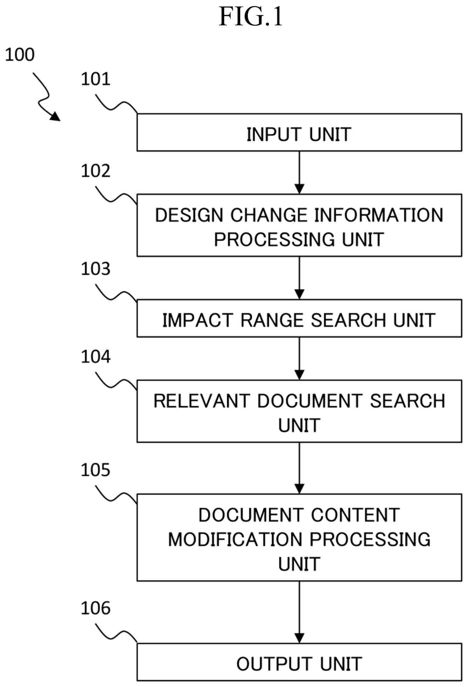

FIG. 1 is a block diagram of a design document editing support apparatus 100 according to Example 1 of the present disclosure. The design document editing support apparatus 100 includes an input unit 101, a design change information processing unit 102, an impact range search unit 103, a relevant document search unit 104, a document content modification processing unit 105, and an output unit 106.

The input unit 101 acquires a design document related to the product, a systems model related to the product, and design change information describing which parts are to be subjected to what design changes. The design change information processing unit 102 uses techniques such as natural language processing on the design change information acquired by the input unit 101 to extract information such as the name of the part to be changed, the content of the change, and the amount of change. The impact range search unit 103 uses the information related to the design change acquired by the design change information processing unit 102 and the systems model acquired by the input unit 101 to identify the range affected by the design change based on the connection relationships of elements included in the systems model. The relevant document search unit 104 searches for documents corresponding to the range identified by the impact range search unit 103 in the design document related to the product acquired by the input unit 101. The document content modification processing unit 105 changes the display mode of the document searched by the relevant document search unit 104 to highlight it as a document to be noted (in this example, highlighting). At this time, if it is possible to replace the content of the document using the design change information extracted by the design change information processing unit 102, the content of the design document may be changed. The output unit 106 outputs the design document processed by the document content modification processing unit 105, thereby outputting a design document in which the documents to be changed due to the design change are highlighted and supporting the editing work of the design document.

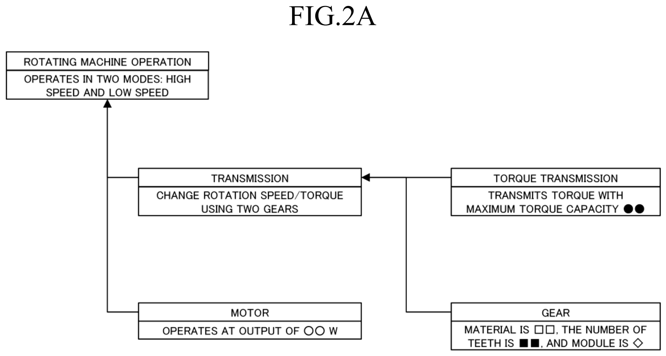

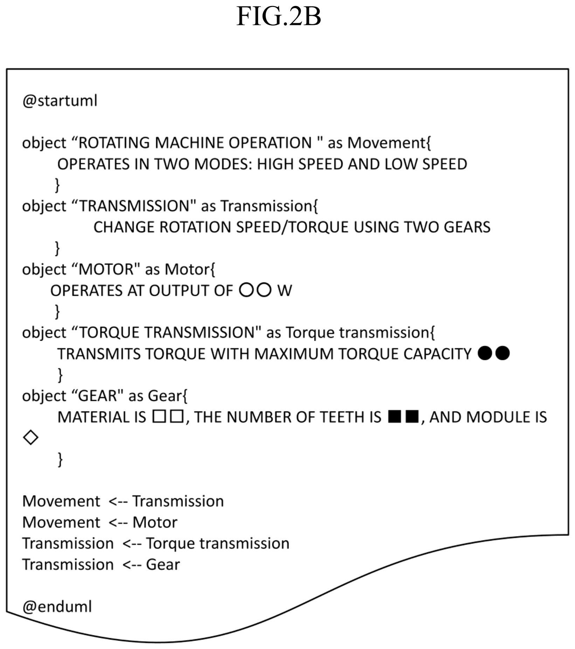

FIG. 2A shows an example of a systems model related to the product. The systems model shown in FIG. 2A describes information related to the product requirements. In the systems model, information related to the product is described as individual elements, and the outline of the elements and details of the information included in the elements can be described. In addition, the systems model can illustrate the connections between elements, thereby visualizing inclusion relationships between elements. FIG. 2B is a script written in a modeling language representing the systems model shown in FIG. 2A. Here, the script is written in the Unified Modeling Language (UML), which is widely used as a modeling language. Modeling languages such as UML describe documents defining blocks displayed in the system model and documents indicating the connection relationships of the respective blocks.

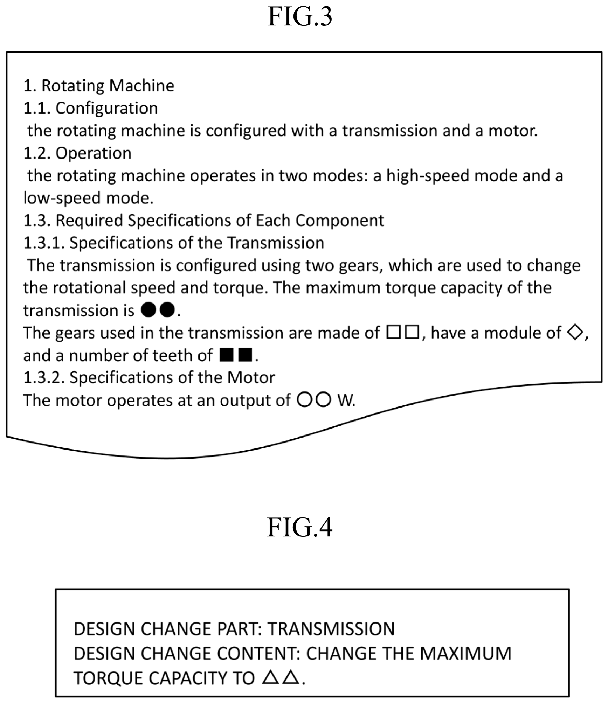

FIG. 3 shows an example of a design document related to the product according to the present disclosure. The design document describes information such as the functions and specifications of the product. When describing the design document, the content may be divided by chapters or sections, or the information may be described without chapters or sections; in the design document of the present disclosure, either format is acceptable.

FIG. 4 shows an example of design change information according to the present disclosure. The design change information describes the part or component to be changed and the specific content of the change. The part or component to be changed and the specific content of the change may be described separately, or may be described in one sentence as natural language.

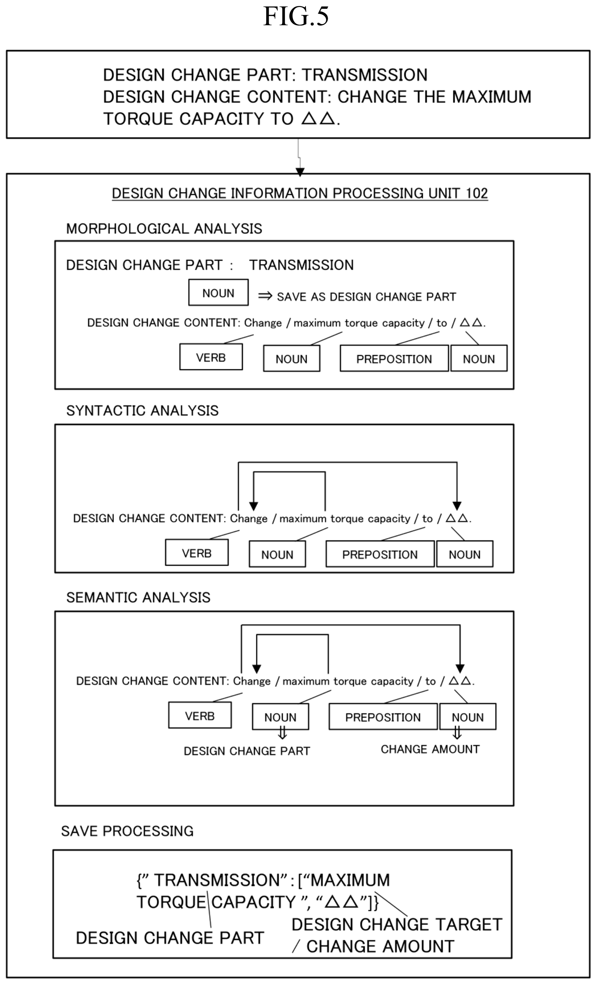

FIG. 5 illustrates an example of processing by the design change information processing unit 102 according to Example 1 of the present disclosure. The design change information processing unit 102 performs morphological analysis, syntactic analysis, and semantic analysis, which are types of natural language processing, on a document written in natural language included in the acquired design change information, obtains dependency relationships between words and numerical values contained in the design change information, and stores which parts are to undergo what changes. The storage format shown in FIG. 5 stores information such as the design change part, the specific design change target, and the change amount as a dictionary; however, the storage format is not limited as long as equivalent information can be stored.

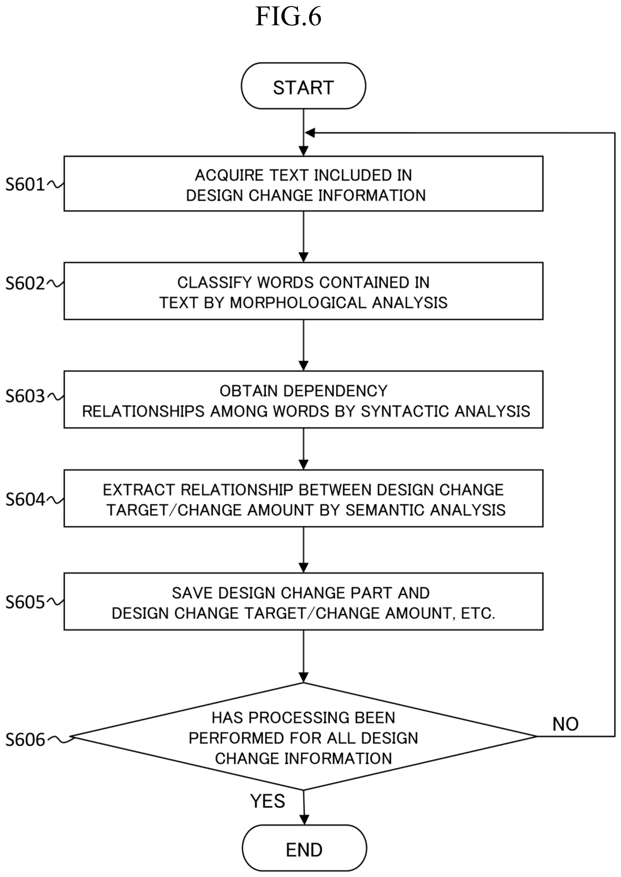

FIG. 6 is a flowchart of the design change information processing unit 102 according to Example 1 of the present disclosure. First, in step S601, text included in the design change information acquired by the input unit 101 is obtained. In step S602, morphological analysis is performed to divide the entire text by part of speech. Next, in step S603, syntactic analysis is performed on words and numerical values obtained as a result of morphological analysis to obtain dependency relationships between the words and numerical values. In addition, in step S604, semantic analysis is performed to obtain, from the words and numerical values contained in the text, which design change part is to be changed, what design change target is to be changed, and based on what change amount. In step S605, the design change part name, design change target, and change amount included in the design change information are collectively stored. In step S606, it is determined whether processing has been performed for all design change information acquired by the input unit 101, assuming that multiple pieces of design change information exist. If processing has not been performed for all design change information, the process returns to step S601 to process the next design change information. If processing has been performed for all design change information, the processing by the design change information processing unit 102 ends.

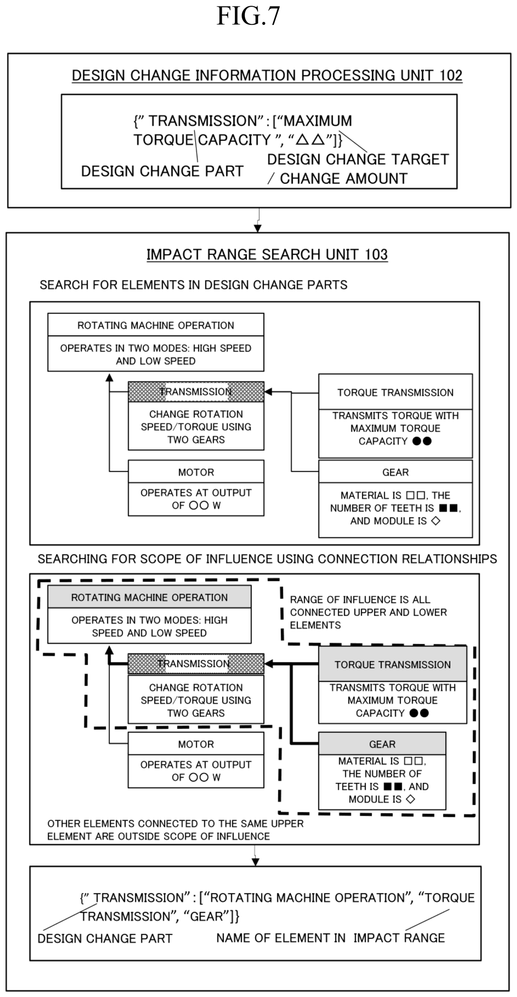

FIG. 7 illustrates an example of processing by the impact range search unit 103 according to Example 1 of the present disclosure. The impact range search is performed using the design change parts, design change targets, and change amounts obtained by the design change information processing unit 102 and the systems model. When performing the impact range search, first, elements in the systems model corresponding to the design change parts are searched. Next, elements connected to the searched elements are searched. At this time, using the hierarchical structure of the systems model, all lower elements connected to the elements corresponding to the design change parts and all elements connected to those lower elements are obtained, as well as all upper elements. Elements connected to the same upper element and elements connected to those lower elements are considered outside the impact range. That is, in the systems model, upper elements directly or indirectly connected to the elements corresponding to the design change parts and lower elements directly or indirectly connected to the elements corresponding to the design change parts are searched as the impact range. Since the systems model includes information indicating the connection relationships of elements contained in the systems model, all upper and lower elements connected to the elements corresponding to the design change parts may be searched using this information. The search results are stored in a dictionary format indicating the element names of the systems model within the impact range for each design change part, but the storage format is not limited thereto.

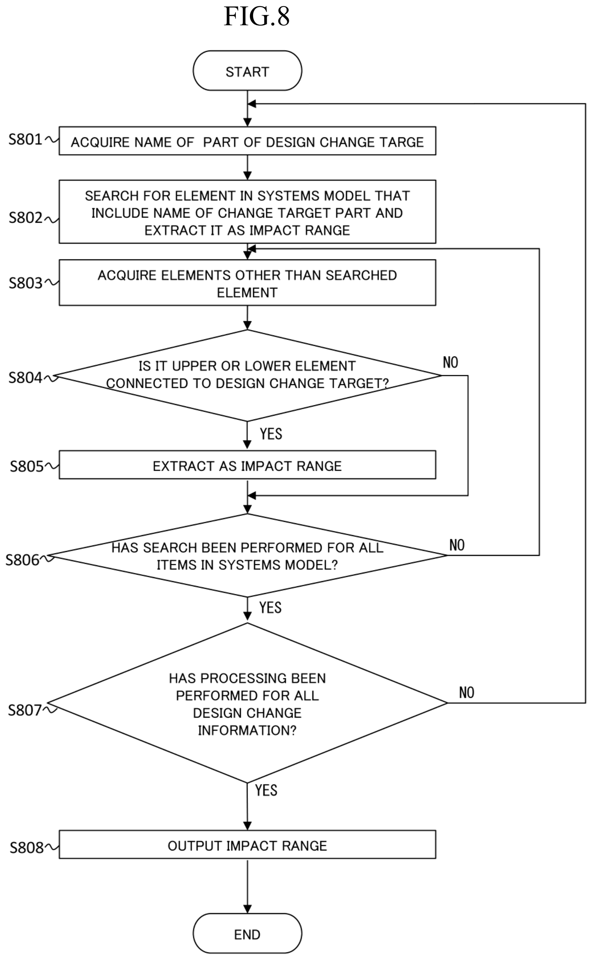

FIG. 8 is a flowchart of the impact range search unit 103 according to Example 1 of the present disclosure. First, in step S801, the design change part name is obtained from information such as the design change part name, design change target, and change amount output from the design change information processing unit 102. In step S802, elements containing the design change part name are obtained from among the elements included in the systems model related to the target product and extracted as the impact range. Next, a search is performed for elements other than the obtained elements. In step S803, elements included in the systems model are obtained, and in step S804, it is determined whether the obtained element is an upper or lower element connected to the element corresponding to the design change target. If the element obtained in step S803 is an upper or lower element connected to the element corresponding to the design change target, the process proceeds to step S805 to extract it as part of the impact range. In step S806, it is determined whether processing has been performed for all elements included in the systems model; if not, the process returns to step S803 to obtain the next element. If processing has been performed for all elements, the process proceeds to step S807 to determine whether processing has been performed for all design change information. If processing has not been performed for all design change information, the process returns to step S801 to process the next design change information. If processing has been performed for all design change information, the process proceeds to step S808, stores and outputs the extracted impact range, and ends the processing.

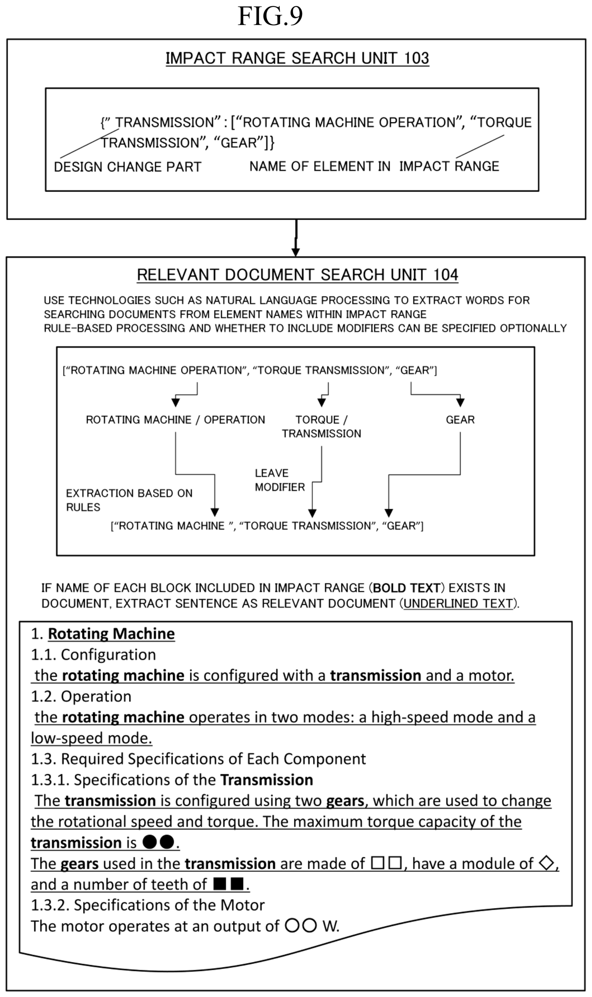

FIG. 9 illustrates an example of processing by the relevant document search unit 104 according to Example 1 of the present disclosure. The relevant document search unit 104 acquires information related to the impact range output by the impact range search unit 103, investigates the content of documents described in the design document, and determines that a document corresponding to the design change part and element names included in the impact range is a portion of the design document affected by the design change. In this case, the element names included in the impact range extracted by the impact range search unit 103 may be described not as single words but as natural language sentences. When obtaining words for searching documents from element names described in natural language, analysis using techniques such as natural language processing may be performed on the element names included in the impact range to obtain words for searching documents. Furthermore, when phrases such as "operation of" or "requirement of" are appended to the element names included in the impact range, rules may be established to remove such phrases and obtain words for searching documents. In addition, when modifiers such as "high load" or "high speed" are appended, the modifiers may be removed and words such as "load" or "speed" may be used for searching; alternatively, for more detailed searching, the modifiers may be retained. The portions searched by the relevant document search unit 104 include all items (elements) in the design document, and therefore, for example, chapter and section titles are also searched.

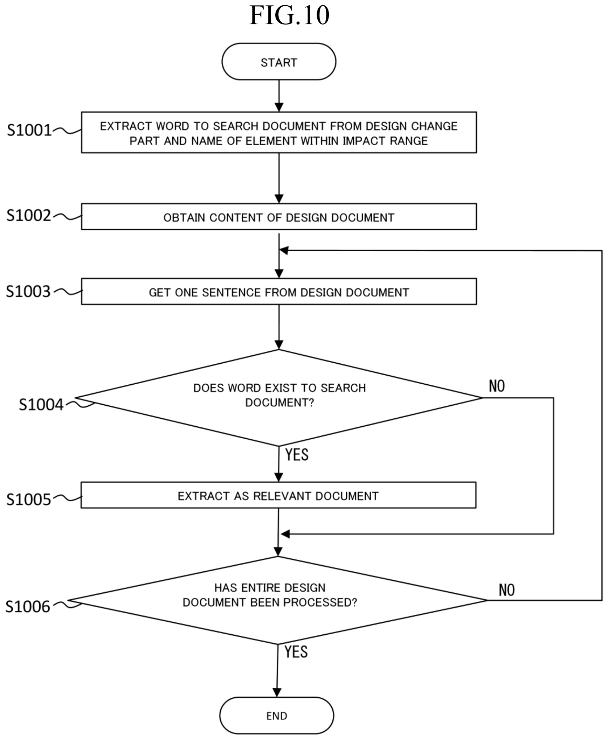

FIG. 10 is a flowchart of the relevant document search unit 104 according to Example 1 of the present disclosure. First, in step S1001, the design change parts and the element names within the impact range extracted by the impact range search unit 103 are obtained, and words for searching documents are extracted by utilizing techniques such as natural language processing. Next, in step S1002, all the content of the documents included in the design document acquired by the input unit 101 is obtained. Then, in step S1003, one sentence of the acquired design document is obtained. In that sentence, it is determined whether the words extracted in step S1001 for searching documents are included; if they are included, the process proceeds to step S1005 and extracts the sentence as the relevant document. In step S1006, it is determined whether processing has been performed for all sentences in the design document; if processing has not been performed for all sentences, the process returns to step S1003 to process the next sentence, and if processing has been performed for all sentences in step S1006, the processing ends.

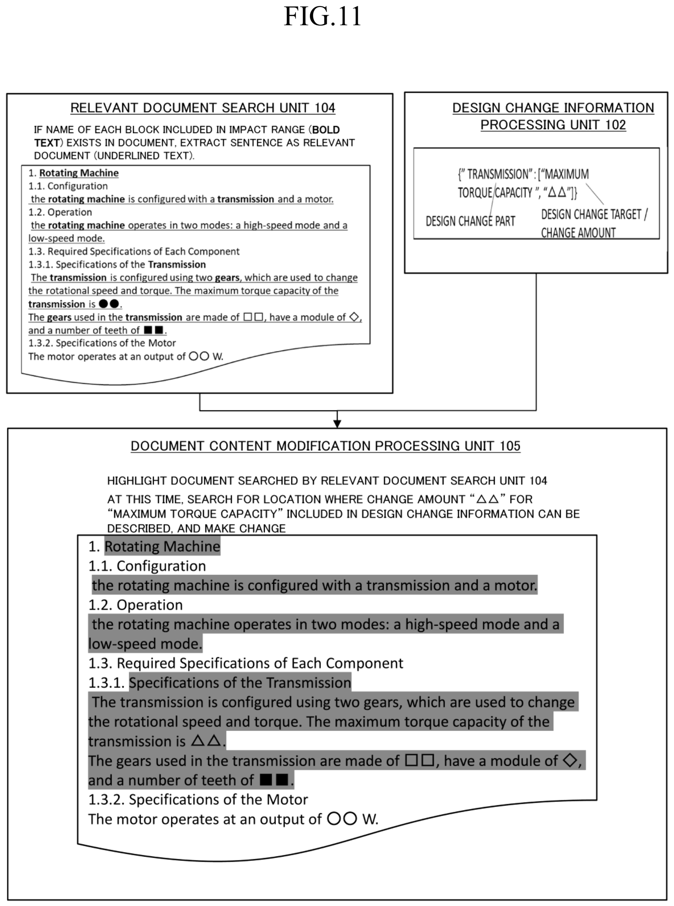

FIG. 11 illustrates an example of processing by the document content modification processing unit 105 according to Example 1 of the present disclosure. The document content modification processing unit 105 outputs a design document in which the relevant document searched by the relevant document search unit 104 is highlighted. At this time, based on the design change parts, design change targets, and change amounts acquired by the design change information processing unit 102, and by utilizing techniques such as natural language processing, if it is determined that the content corresponding to the design change parts or design change targets is included, the content of the document is modified according to the change amount.

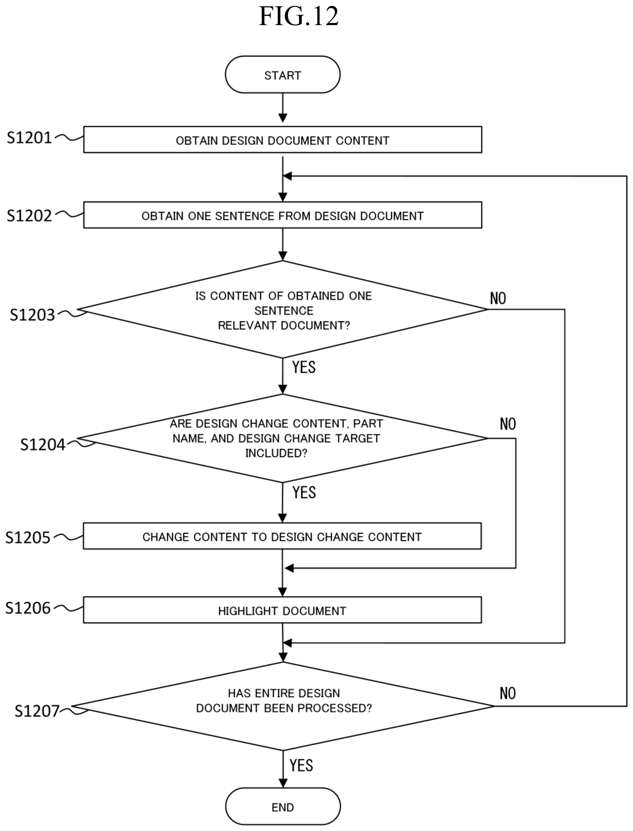

FIG. 12 is a flowchart of the document content modification processing unit 105 according to Example 1 of the present disclosure. First, in step S1201, all the content described in the design document acquired by the input unit 101 is obtained. Next, in step S1202, one sentence is obtained from the acquired design document. Then, in step S1203, it is determined whether the obtained sentence is a relevant document searched by the relevant document search unit 104; if it is, the process proceeds to step S1204, and if it is not, the process proceeds to step S1207. In step S1204, it is determined whether the obtained sentence in the design document includes the design change part name or design change target contained in the design change content acquired by the design change information processing unit 102; if it is determined to be included, the process proceeds to step S1205, and if not, the process proceeds to step S1206. When the design change part name and design change target are included, in step S1205, the content of the obtained sentence is modified based on the design change target and the change amount. At this time, techniques such as natural language processing may be utilized to perform morphological analysis, syntactic analysis, and semantic analysis, and then replace the design change target and change amount to modify the content of the document. Next, in step S1206, the relevant document is highlighted. Then, in step S1207, it is determined whether processing has been performed for all content included in the design document; if not, the process returns to step S1202, and if processing has been performed for all content, the processing ends.

The output unit 106 according to Example 1 of the present disclosure outputs the design document processed by the document content modification processing unit 105 and ends the processing related to editing the design document accompanying the design change.

The design document editing support apparatus 100 according to Example 1 of the present disclosure can identify portions to be changed and portions affected by the design change when performing a product design change based on design change information. Furthermore, by highlighting portions corresponding to the above in the design document and replacing content, it is expected to reduce the man-hours required for editing the design document and prevent omissions.

### <<Example 2>>

This embodiment modifies the design document editing support apparatus 100 of Example 1 so that the systems model used by the impact range search unit 103 and the design document used by the relevant document search unit 104 and the document content modification processing unit 105 are each acquired from a dedicated database. By storing the systems model and the design document related to the product in respective databases, it becomes possible to simultaneously acquire the systems model and the design document using the product name that is the target of the design change. This facilitates management of the systems model and the design document used in design and prevents inconsistencies between the systems model and the design document by acquiring them simultaneously.

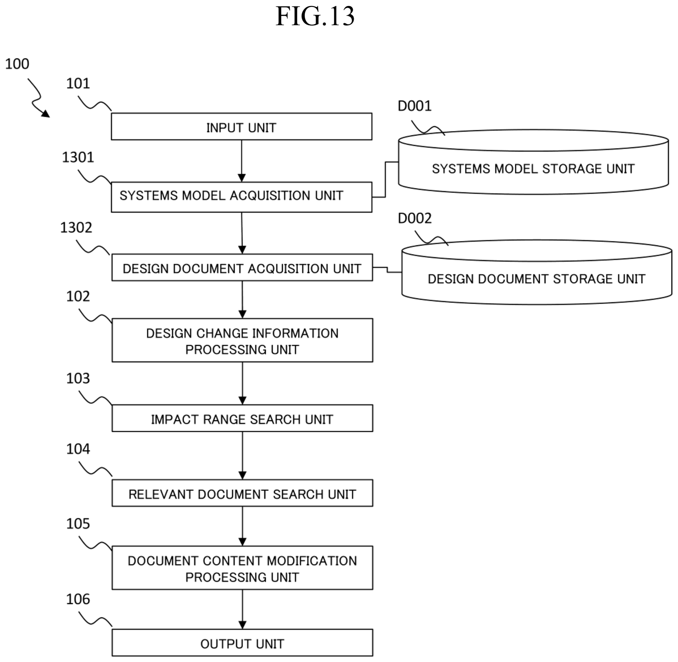

FIG. 13 is a block diagram according to Example 2 of the present disclosure. The configuration of Example 2 includes: an input unit 101; a systems model acquisition unit 1301; a design document acquisition unit 1302; a design change information processing unit 102; an impact range search unit 103; a relevant document search unit 104; a document content modification processing unit 105; an output unit 106; a systems model storage unit D001; and a design document storage unit D002. The systems model storage unit D001 and the design document storage unit D002 store systems models and design documents for each product, and allow searching and acquiring the systems model and the design document using the product name.

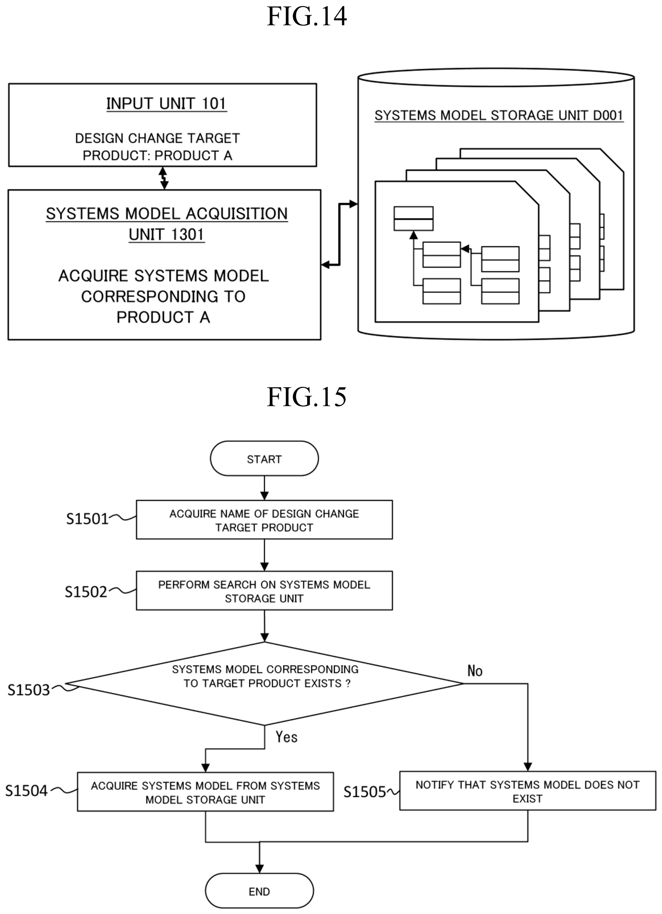

FIG. 14 illustrates an example of processing by the systems model acquisition unit 1301 according to Example 2 of the present disclosure. In the input unit 101, in addition to the target part and design change content as design change information, the product to be subjected to the design change is also input. The systems model acquisition unit 1301 acquires the product name that is the target of the design change from the input unit 101, searches the systems model storage unit D001, and acquires the systems model.

FIG. 15 is a flowchart of the systems model acquisition unit 1301 according to Example 2 of the present disclosure. First, in step S1501, the product name to be subjected to the design change is acquired from the content input by the input unit 101. Next, in step S1502, a search is performed in the systems model storage unit D001 to determine whether a systems model having the acquired product name exists. In step S1503, it is determined whether the systems model related to the target product exists in the systems model storage unit D001; if it exists, the process proceeds to step S1504, and if it does not exist, the process proceeds to step S1505. In step S1504, the systems model for the product to be subjected to the design change is acquired from the systems model storage unit D001, and the processing ends. On the other hand, in step S1505, the user is notified that the systems model related to the target product does not exist in the systems model storage unit D001, and the processing ends.

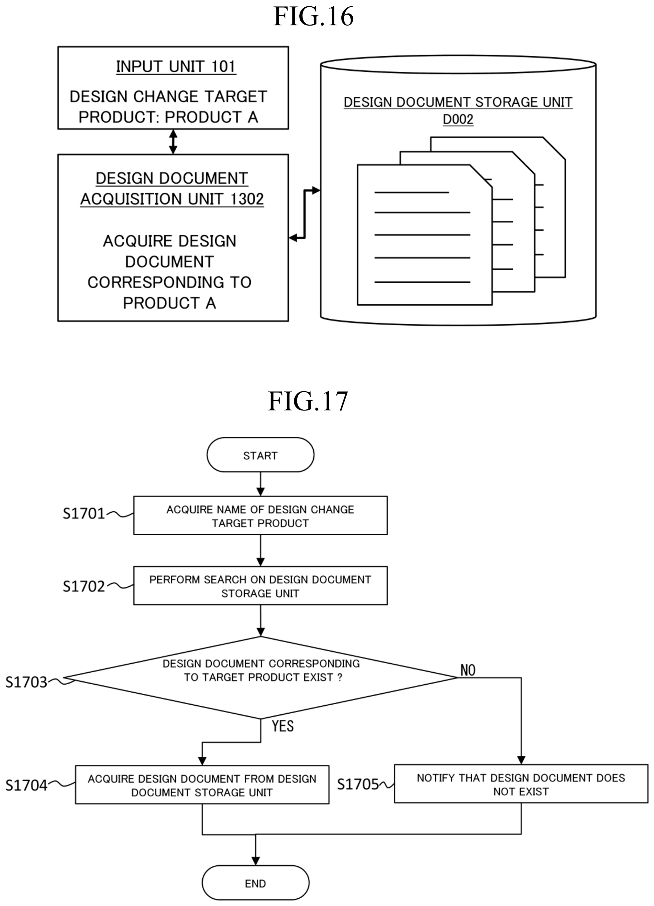

FIG. 16 illustrates an example of processing by the design document acquisition unit 1302 according to Example 2 of the present disclosure. The design document acquisition unit 1302 acquires information on the product to be subjected to the design change input by the input unit 101, and searches the design document storage unit D002 using the acquired product name to acquire the design document.

FIG. 17 is a flowchart of the design document acquisition unit 1202 according to Example 2 of the present disclosure. First, in step S1701, the product name to be subjected to the design change is acquired from the content input by the input unit 101. Next, in step S1702, a search is performed in the design document storage unit D002 to determine whether a design document having the acquired product name exists. In step S1703, it is determined whether the design document related to the target product exists in the design document storage unit D002; if it exists, the process proceeds to step S1704, and if it does not exist, the process proceeds to step S1705. In step S1704, the design document related to the target product is acquired from the design document storage unit D002, and the processing ends. On the other hand, if the design document does not exist in the design document storage unit D002, in step S1705, the user is notified that the design document does not exist, and the processing ends.

The design document editing support apparatus 100 according to Example 2 of the present disclosure exhibits the same effects as Example 1.

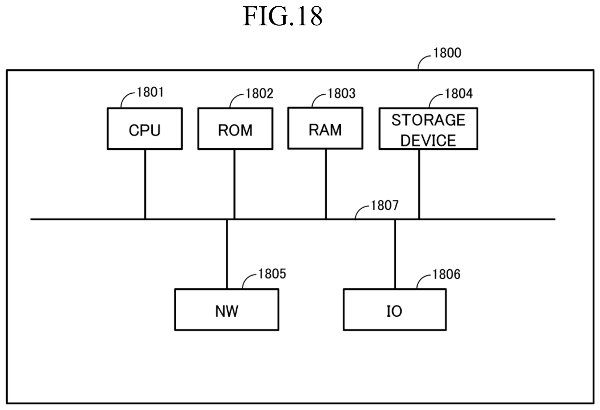

FIG. 18 is a diagram illustrating an example of a hardware configuration of a computer 1800 applied to the design document editing support apparatus 100 according to Examples 1 and 2 of the present disclosure. The design document editing support apparatus 100 may be configured by a plurality of computers or may be a virtual computer on a cloud.

The computer 1800 may be referred to as an "information processing apparatus." The computer 1800 includes a processor (CPU 1801), a ROM 1802, a RAM 1803, a nonvolatile storage device 1804 capable of reading and writing data, a network interface 1805, and an input/output interface 1806. These are connected to each other via a bus 1807 so as to be communicable.

The CPU 1801 loads various programs stored in the ROM 1802 and/or the storage device 1804 into the RAM 1803 and executes the programs loaded in the RAM 1803, thereby functioning as an arithmetic unit that realizes various functions of the design document editing support apparatus 100 described above. The RAM 1803 temporarily stores various programs loaded as described above for execution by the CPU 1801, as well as data used when the CPU 1801 executes the programs. The ROM 1802 and/or the storage device 1804 are nonvolatile storage media, and various programs are stored therein. The input unit 101, the design change information processing unit 102, the impact range search unit 103, the relevant document search unit 104, the document content modification processing unit 105, and the output unit 106 described above are configured by programs.

The network interface 1805 is an interface for connecting the computer 1800 to a network.

The storage device 1804 stores the systems model storage unit D001 and the design document storage unit D002.

The input/output interface 1806 is an interface for connecting the computer 1800 to an operation device (not shown) and a display device (display) capable of displaying images (not shown). The input unit 101 acquires information input by the user via the operation device as input information. The output unit 106 generates screens (images (GUI images)) to be output to the display device and outputs the generated screens to the display device.

The computer 1800 may be partially or entirely configured by an FPGA (Field Programmable Gate Array) or the like.

### <<Modifications>>

The present disclosure is not limited to the above embodiments and various modifications can be adopted within the scope of the present disclosure. In the design document editing support apparatus 100 of the above embodiments, the portions corresponding to the impact range are displayed by highlighting; however, the portions corresponding to the impact range may be displayed in a display mode different from others (for example, a different color, bold type, etc.) by a method other than highlighting.

### Reference Signs List

100 : Design document editing support apparatus
101: Input unit
102 : Design change information processing unit
103: Impact range search unit
104 : Relevant document search unit
105: Document content modification processing unit
106 : Output unit
1301: Systems model acquisition unit
1302: Design document acquisition unit
D001: Systems model storage unit
D002 : Design document storage unit

## Claims

1. A design document editing support apparatus including an information processing device,
wherein
the information processing device:
acquires product model information representing a target product by a plurality of elements hierarchically connected, a design document, and design change information;
extracts, from the content included in the design change information, a change location for the target product and a change target and change content of the change target related to the change location;
identifies, based on the extracted change location, a change element corresponding to the change location from among the plurality of elements included in the product model information;
searches, as an impact range, the identified change element and elements connected to the identified change element in the product model information; and
identifies, in the design document, a description portion corresponding to the searched impact range.

2. The design document editing support apparatus according to claim 1,
wherein
the information processing device searches, as the impact range, upper elements directly or indirectly connected to the identified change element and lower elements directly or indirectly connected to the identified change element in the product model information.

3. The design document editing support apparatus according to claim 1,
wherein
the information processing device changes the display mode of the description portion corresponding to the identified impact range to a display mode different from others.

4. The design document editing support apparatus according to claim 3,
wherein
the information processing device uses highlighting as the display mode different from others.

5. The design document editing support apparatus according to claim 3,
wherein
the information processing device is configured to display an image on a display device, and
the information processing device displays, on the display device, an image including at least a part of the design document including the description portion corresponding to the identified impact range, the description portion corresponding to the identified impact range being changed to the display mode different from others.

6. The design document editing support apparatus according to claim 1,
wherein
the information processing device extracts words for identifying the description portion corresponding to the searched impact range from the searched impact range, and identifies, in the design document, a sentence including the extracted words as the description portion corresponding to the searched impact range.

7. The design document editing support apparatus according to claim 3,
wherein
the information processing device changes the content of a portion corresponding to the change target and the change content of the change target related to the extracted change location in the description portion corresponding to the identified impact range, based on the extracted change content of the change target.

8. The design document editing support apparatus according to claim 7,
wherein
the information processing device determines whether the description portion corresponding to the identified impact range includes a portion corresponding to the change target and the change content of the change target related to the extracted change location based on the change target and the change content of the change target related to the extracted change location; and
replaces, when the description portion corresponding to the identified impact range includes the portion corresponding to the change target and the change content of the change target related to the extracted change location, the content of the portion corresponding to the change target and the change content of the change target related to the extracted change location with the change content of the extracted change target.

9. The design document editing support apparatus according to claim 1,
wherein
the information processing device includes a storage device storing the product model information related to the target product; and
the information processing device acquires the product model information corresponding to the target product from the storage device using a product name of the target product.

10. The design document editing support apparatus according to claim 1,
wherein
the information processing device includes a storage device storing the design document related to the target product; and
the information processing device acquires the design document corresponding to the target product from the storage device using a product name of the target product.

11. The design document editing support apparatus according to claim 1,
wherein
the information processing device uses a natural language processing technique on the content included in the design change information to recognize a subject and predicate as a document structure of the content, and obtains the change location, the change target, and the change content of the change target from dependency relationships between the subject and predicate.

12. The design document editing support apparatus according to claim 1,
wherein
the information processing device includes a storage device; and
the information processing device stores, in the storage device, names of elements searched as the impact range as search results.

13. The design document editing support apparatus according to claim 1,
wherein
the product model information is a systems model.

14. The design document editing support apparatus according to claim 1,
wherein
the change content of the change target includes a change amount of the change target.

15. A design document editing support method using an information processing device,
wherein
the information processing device:
acquires product model information representing a target product by a plurality of elements hierarchically connected, a design document, and design change information;
extracts, from the content included in the design change information, a change location for the target product and a change target and change content of the change target related to the change location;
identifies, based on the extracted change location, a change element corresponding to the change location from among the plurality of elements included in the product model information;
searches, as an impact range, the identified change element and elements connected to the identified change element in the product model information; and
identifies, in the design document, a description portion corresponding to the searched impact range.
